# FASCICULE DE BREVET EUROPEEN

(11) **EP 1 692 716 B1**
(45) Date de publication et mention de la délivrance du brevet: **20.11.2019**
(21) Numéro de dépôt: 04816510.4
(22) Date de dépôt: 06.12.2004
(51) Int. Cl.: H01L 21/58, H01L 21/98, H01L 25/065

(54) **COLLAGE MOLECULAIRE DE COMPOSANTS MICROELECTRONIQUES SUR UN FILM POLYMERE**
MOLEKULARKLEBEN VON MIKROELEKTRONISCHEN KOMPONENTEN AN EINER POLYMERFOLIE
METHOD FOR THE MOLECULAR BONDING OF MICROELECTRONIC COMPONENTS TO A POLYMER FILM

(30) Priorité: 08.12.2003 FR 0350999
(43) Date de publication de la demande: 23.08.2006
(73) Titulaire: Commissariat à l'Énergie Atomique et aux Énergies Alternatives, 75015 Paris (FR)
(72) Inventeur: MORICEAU, Hubert, F-38120 SAINT EGREVE (FR); MORALES, Christophe, 38220 Vizille (FR); DI CIOCCIO, Léa, F-38330 SAINT ISMIER (FR)
(74) Mandataire: Ahner, Philippe
(86) Numéro de dépôt international: PCT/FR2004/050656
(87) Numéro de publication internationale: WO 2005/057637

(56) Documents cités:
- FR-A- 2 787 919
- US-A- 4 983 251
- US-A1- 2003 211 705

## Description

### DOMAINE TECHNIQUE

L'invention se rapporte à l'adhésion de composants microélectroniques sur un support comprenant un polymère.

Plus particulièrement, l'invention concerne sous un de ses aspects un procédé de collage tel que l'adhésion moléculaire est rendue possible sur une surface recouverte, au moins partiellement, d'un polymère.

Sous un autre aspect, l'invention a pour objet un empilement de composés électroniques issu de ce procédé.

### ETAT DE LA TECHNIQUE ANTERIEURE

Pour réaliser des structures empilées, l'adhésion des différents niveaux est souvent assurée par des colles, des cires ou même des polymères photosensibles : les substances adhésives sont en général épandues sur une ou sur les deux surfaces à assembler et une étape de séchage ou de durcissement permet d'assurer le collage.

On connaît également, dans le domaine électronique, des procédés d'empilement de structures par adhésion moléculaire. Cependant, dans ce cas, il est systématiquement recommandé d'éliminer les hydrocarbures pour permettre un collage de bonne qualité (voir par exemple l'ouvrage de Q.Y. Tong et U. Gosele « Semiconductor Wafer Bonding , Science and Technology », John Wiley and Sons, Inc., New York (1999), paragraphe 5.4.2).

Par ailleurs, une surface plane est préférable pour assurer une adhésion moléculaire durable. Les films polymères ne se présentent donc pas favorablement pour de tels collages directs : outre leur contenu important en hydrocarbures, ils présentent une porosité surfacique non négligeable.

Le développement de la microélectronique, la miniaturisation des composants et la complexité croissante des assemblages ont mené au souhait de réalisation de structures à trois dimensions, dans lesquelles des puces, épaisses et/ou minces, sont empilées sur des plaques de composés déjà mises en forme.

En particulier, sur le support initial des empilements, des composants électroniques sont mis en place selon des procédés classiques afin d'obtenir une plaque hôte. De tels procédés s'achèvent en général par des étapes permettant de réaliser les connexions électriques, par exemple dans un épandage de matériau photosensible, tel que le benzocyclobutène (BCB). Le matériau photosensible présent à la surface de la plaque hôte est normalement un polymère : le problème est alors d'être capable de positionner des puces ou autres composants électroniques à la surface du polymère pour réaliser la structure tridimensionnelle.

Le collage traditionnel n'est pas sans poser de problèmes car tout apport de colle, polymère, cire... crée une épaisseur supplémentaire difficile à gérer dans un tel empilement, et présente comme autre inconvénient la création possible de bulles à l'interface de collage. Il a par ailleurs été montré que des structures minces collées sur un support via une couche « épaisse » de colle avaient tendance à onduler, suivant la nature de l'adhésif, suivant leur épaisseur relative, etc.

Le document US 2003/211705 A1 décrit un procédé d'adhésion moléculaire utilisant une couche de liaison entre les éléments solidarisés.

### EXPOSÉ DE L'INVENTION

L'invention se propose, parmi autres avantages, de pallier les inconvénients mentionnés pour l'adhésion de composants microélectroniques sur des surfaces polymériques.

L'invention selon la revendication 1 propose d'utiliser l'adhésion moléculaire directe. A cette fin, le procédé selon l'invention sous un de ses aspects permet de s'affranchir des problèmes occasionnés par la présence de la couche polymérique, en la recouvrant d'une couche de liaison permettant ladite adhésion moléculaire. De façon surprenante, il a été trouvé que le polymère ne contamine pas en hydrocarbures cette couche de liaison : une adhésion moléculaire est donc réalisée en présence d'un polymère, c'est-à-dire d'hydrocarbures, dont les résultats sont de qualité, contrairement aux préjugés de l'état de la technique. Avantageusement, la couche de liaison présente au niveau de sa face à assembler des propriétés hydrophiles obtenues spontanément ou après un traitement spécifique connu de l'homme du métier. Par ailleurs, la couche de liaison est de préférence inerte chimiquement et compatible avec des étapes ultérieures mises en œuvre habituellement en microélectronique. Les matériaux préférés pour réaliser une telle couche de liaison sont les oxydes, les nitrures ou une couche composite, en particulier SiO₂, SiₓN_{y}, SiₓO_{y}N_{z}. La couche de liaison peut également être constituée d'un empilement de plusieurs des couches précitées.

Avantageusement, la couche de liaison est polie afin d'obtenir une surface plane d'adhésion ; suivant les conditions utilisées, un tel polissage est possible sans arrachement de la couche de liaison du polymère, totale ou partielle, qui entraînerait une contamination par des hydrocarbures. Il n'est ainsi pas nécessaire de polir au même degré la couche de polymère, procédé plus difficilement contrôlable que le polissage d'une couche en oxyde de silicium par exemple, ou autres matériaux de la couche de liaison.

Il est également possible de préparer la surface de la couche de liaison selon des procédés permettant d'augmenter les énergies d'adhésion. A cette fin également, le procédé selon l'invention propose avantageusement de préparer la surface de contact du composé qui sera placé sur la couche de liaison.

Il peut être préférable de préparer le polymère préalablement au dépôt de la couche de liaison, par exemple en opérant une réticulation. Il peut également être envisagé de consolider l'ensemble après adhésion moléculaire par un traitement thermique.

Sous un autre aspect, l'invention concerne une structure de composés électroniques en trois dimensions comprenant un empilement, dont certaines adhésions entre couches successives, et plus généralement entre niveaux successifs, sont directes, avec dépôt d'au moins une couche d'interface, en oxyde de silicium par exemple.

### BRÈVE DESCRIPTION DES DESSINS

Les figures des dessins annexés permettront de mieux comprendre l'invention, mais ne sont données qu'à titre indicatif et ne sont nullement restrictives.
Les figures la à 1d représentent schématiquement les différentes étapes d'un procédé selon un mode de réalisation préféré de l'invention.

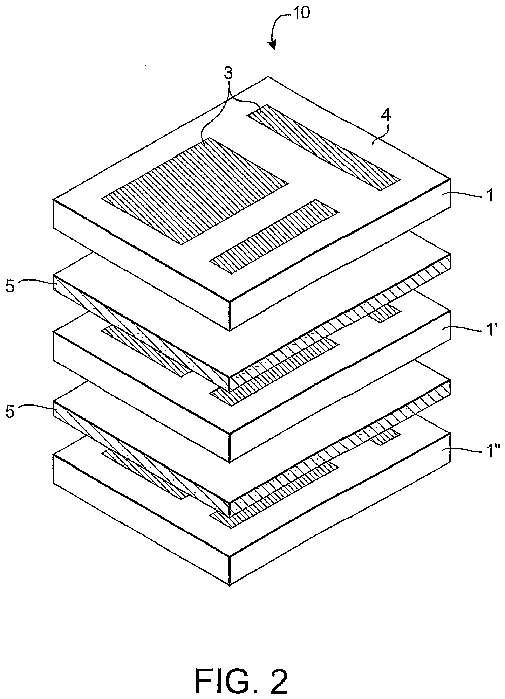

La figure 2 montre, en éclaté, un mode de réalisation de l'invention concernant un empilement tridimensionnel.

### EXPOSÉ DÉTAILLÉ DE MODES DE RÉALISATION PARTICULIERS

L'invention trouve une application particulière dans les empilements de structures électroniques ou optiques, ou optoélectroniques par exemple, pour atteindre des matrices en trois dimensions constituées de plaques comprenant des composants, par exemple électroniques ou optiques... Ces plaques peuvent elles-mêmes être constituées de supports sur lesquels des composants, éventuellement différents, ont été solidarisés et dont les connexions ont été réalisées. L'exemple le plus simple concerne cependant un composant électronique unique, ou puce, que l'on désire « coller » à la surface d'un composé électronique, ou plaque hôte, classique.

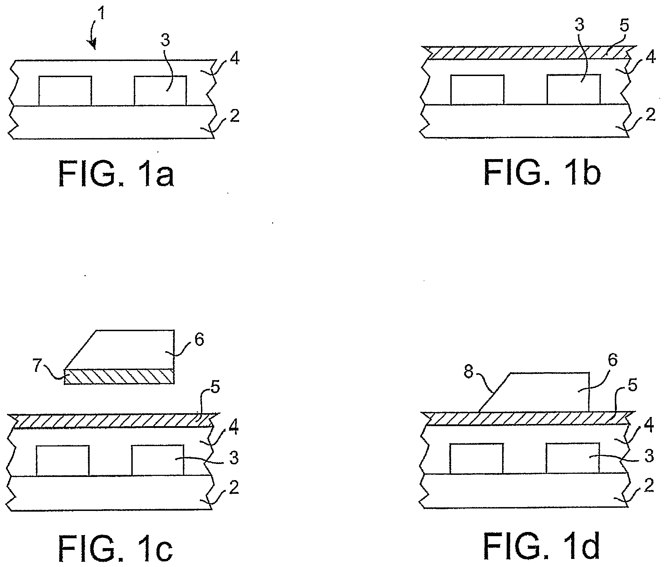

Une telle plaque (1), illustrée sur la figure 1a, est constituée d'un support (2) sur lequel différents composants électroniques (3) ont été réalisés selon des techniques connues. Le support (2) est partiellement recouvert d'un polymère (4), par exemple utilisé lors d'une des étapes menant à la connexion électrique des composants (3) de la plaque hôte (1), et dont l'épaisseur varie habituellement entre 1 et 20 µm, de préférence restant inférieure à 10 µm ; la surface de la plaque hôte (1) peut en particulier contenir un film de BCB, mais une colle ou une cire sont d'autres possibilités.

Pour le procédé selon l'invention, il est préférable de préparer le polymère (4) de surface, notamment de le sécher, afin de le stabiliser. En particulier, il est souhaitable de procéder à une réticulation supplémentaire du polymère, par exemple par traitement thermique avec chauffage entre 150 et 400°C, lors d'une des étapes finales de formation de la plaque hôte (1). Par exemple, pour un film de BCB, typiquement de l'ordre de 6 µm, un traitement thermique de 2 h à 250°C ou 300°C, voire de 30 min à 350°C, est envisageable.

Le polymère (4) est alors recouvert d'une couche de liaison (5), si possible inerte chimiquement et apte à supporter les traitements usuels en microélectronique, de préférence sous forme d'un film déposé : figure 1b. La couche de liaison est de préférence constituée d'oxyde de silicium, ou il est possible de choisir un nitrure ou un oxynitrure de silicium ; elle peut cependant être composée de tout matériau susceptible de former une couche avantageusement hydrophile (par sa nature ou par un traitement adapté) de façon à assurer une adhésion moléculaire. La couche de liaison (5) peut être uniforme, mais elle peut également être composée d'une superposition de couches uniformes telles que décrites ci-dessus, par exemple une couche de SiO₂ recouvrant une couche SiₓO_{y}N_{z}.

Si le composé électronique (3) comporte à sa surface des zones exemptes de polymère (4), seul le polymère peut être recouvert, mais il est plus facile de recouvrir la surface complète de la plaque (1). L'oxyde de silicium (5), ou autre matériau, peut être déposé par des techniques connues, par exemple selon un procédé du type « low stress » (c'est-à-dire à faible contrainte), à 220°C par exemple, ou un procédé de dépôt en phase vapeur par voie chimique assistée, connue sous le terme anglo-saxon « Plasma Enhanced Chemical Vapor Déposition », à une température de 300°C par exemple. Il est bien sûr souhaitable que la température de dépôt soit compatible avec la réticulation décrite précédemment. L'épaisseur de la couche de liaison (5) réalisée peut être comprise entre 50 et 300 nm, de préférence de l'ordre de 150 nm ; de façon surprenante, ces épaisseurs sont suffisantes pour assurer une barrière aux hydrocarbures présents dans le polymère (4). L'épaisseur est choisie en particulier relativement fine pour éviter un effet raidisseur trop important, mais suffisamment épaisse pour permettre les traitements ultérieurs, en particulier par exemple le polissage pour rendre la surface plane.

En effet, la surface de la couche de liaison (5) est ensuite de préférence préparée en vue du collage. En particulier, un polissage est souhaitable, pour obtenir une mise à plat de la surface et une microrugosité suffisantes pour permettre un collage direct ultérieur. Le polissage peut être effectué par un procédé de type mécano chimique, par exemple un polissage mécano chimique (CMP, pour « chemical mechanical polishing ») ou un polissage à l'eau sur un tissu spécifique, connu également sous le nom de « nettoyage de slurry ». Le polissage permet également de diminuer l'épaisseur de la couche d'oxyde jusque 30-150 nm ; on peut par exemple enlever 80 nm sur 150 nm. Cette étape, contre toute attente, n'entraîne pas d'arrachement, partiel ou total, de la couche de liaison (5) qui, outre les rugosités, entraînerait une contamination par les hydrocarbures. Parallèlement au polissage, ou en remplacement, la surface peut être activée en vue de l'adhérence moléculaire ultérieure, par exemple avec un mélange d'eau oxygénée et d'ammoniaque, plus ou moins dilué à l'eau. Il est possible également de traiter le film d'oxyde de silicium par l'une ou l'autre des techniques suivantes, seule ou en combinaison : traitement ultraviolets, ozone, ou toute autre préparation de surface permettant de fortes énergies d'adhésion comme le traitement par plasma (sous oxygène, argon, azote, hydrogène,...).

De même, pour améliorer l'adhésion, la surface, active ou non, de la puce (6) (voir figure 1c) qui va venir au contact de la couche d'oxyde de silicium peut être nettoyée et/ou polie et/ou subir un traitement spécifique similaire aux préparations mentionnées pour la couche de liaison (5). Il est possible également de la recouvrir d'une couche d'oxyde de silicium (7) polie, ou de toute autre couche analogue à celle recouvrant le polymère. Il est également possible de procéder, par des techniques standard connues de l'homme du métier, à un traitement permettant d'augmenter de façon contrôlée la rugosité d'au moins l'un des films d'oxyde (5, 7), afin par exemple de permettre ultérieurement un décollage au niveau de cette surface rugueuse. Bien sûr, la rugosité résultante restera compatible avec le collage moléculaire (voir H. Moriceau et al., « The bonding energy control : an original way to debondable substrates », Conference of International Electro-Chemical Society, Paris, Juin 2003). Cette variante est particulièrement avantageuse dans le cas d'assemblages tridimensionnels dont on souhaite éliminer un des niveaux empilés, par exemple après avoir testé ce niveau.

La puce (6) est ensuite de préférence collée directement sur la surface du composé électronique (1) revêtue de SiO₂ : figure 1d. Le collage direct par adhésion moléculaire peut être effectué sur la face active de la puce, comme sur sa face inactive, selon le besoin. Pour plus de précisions concernant l'adhésion moléculaire, on pourra se reporter à l'ouvrage de Q.Y. Tong et U. Gosele « Semiconductor Wafer Bonding, Science and Technology », John Wiley and Sons, Inc., New York (1999).

Pour renforcer le collage direct, un traitement thermique complémentaire peut être effectué, par exemple une consolidation à des températures supérieures à 100°C.

Le procédé selon l'invention permet donc un collage entre une puce (6) et un composé électronique (1), dont la surface contient un polymère (4), exempt de toute gestion de substance adhésive supplémentaire ; en particulier, aucun bourrelet de colle ne déborde de la puce et les problèmes de choix de paramètres (nature et forme de la colle, étalement de gouttes,...) permettant notamment d'éviter la création de bulles pendant le collage sont naturellement résolus.

De plus, la structure finale, collée, présente une épaisseur plus faible et mieux contrôlée que dans le cas de l'utilisation d'un adhésif, qui ajoute une épaisseur difficilement prévisible. Certes, une couche d'oxyde (5) est rajoutée, mais son épaisseur reste faible (notamment très inférieure à 1 µm) et de toute façon bien contrôlée.

La faible épaisseur due au collage proprement dit (c'est-à-dire l'épaisseur de la couche de SiO₂ résultant du procédé, entre 30 et 300 nm par exemple, de préférence de l'ordre de 50 nm) facilite en outre un passage de la marche, située entre la puce et la plaque hôte, facilité pour les reprises de contact sur les bords de puce : on peut aisément mettre en contact la face non collée de la puce et le support initial dans le cas présent, où seuls quelques micromètres au maximum (en fait, l'épaisseur de la puce (6)) les séparent. Il peut être souhaitable pour faciliter encore le passage de la marche d'utiliser un biseau (8) sur les bords de la puce (6). Le biseau (8) peut correspondre à un profil obtenu par gravure (par exemple par gravure chimique anisotrope, sensible à l'orientation cristalline dus plans du biseau) ou par clivage (par exemple suivant une direction cristalline privilégiée : dans le cas de plaques de silicium <100> utilisées pour la réalisation de puces, les faces de clivage seront par exemple les plans <111> correspondant à un angle de 54°7).

Par ailleurs, la préparation, et notamment la mise à plat, de la surface de la plaque hôte préalablement au collage, sont plus aisées que dans le cadre de l'utilisation d'une substance adhésive rapportée : il est possible de laisser la surface du polymère telle qu'elle est après dépôt, notamment si le film polymérique est de faible épaisseur, ou de n'effectuer qu'un polissage grossier, la surface de collage étant définie par celle de la couche de liaison, dont le polissage est mieux maîtrisé et contrôlable que pour un polymère.

Le collage des puces par adhésion moléculaire est en outre plus facilement piloté, par exemple dans le positionnement des puces, que le collage par substance adhésive, d'autant plus si les puces sont minces. Des puces fortement amincies, ou (selon un exemple que ne fait pas partie de l'invention) des films, peuvent également être collés sur du BCB recouvert d'un film d'oxyde par report : un support intermédiaire de transfert de ces puces peut être utilisé dans le procédé selon l'invention. La puce amincie est ainsi solidarisée temporairement avec un support, la surface laissée libre est préparée spécifiquement tel que décrit précédemment pour permettre un collage direct avec le support final recouvert du polymère et du film de liaison. Le support intermédiaire est ensuite désolidarisé après l'adhésion selon des techniques connues (voir par exemple FR 2 796 491). On constate une forte diminution de la tendance à l'ondulation des éléments (puces ou films) transférés par rapport au collage classique à l'aide d'une substance adhésive, voire la suppression de ce phénomène.

Un autre avantage important du procédé selon l'invention est de permettre l'amincissement des puces collées sur le BCB et le film d'oxyde, et ce sans phénomène d'ondulations, ou presque. Si la face active de la puce a été mise en contact pour adhérence sur la couche de SiO₂, la majeure partie de la face arrière de la puce peut en effet être retirée, par rodage, polissage, attaque chimique, décollement, technique de retrait de piédestal connue sous le nom de « lift off », etc..., pour ne laisser qu'un film mince contenant la surface active du côté de l'interface de collage.

La description ci-dessus concerne le collage d'une puce sur une plaque de composé électronique, mais il est clair qu'une généralisation à plusieurs formes de composé électronique est directement dérivable ; par composé électronique, on entend d'ailleurs tout composé obtenu par des moyens classiquement utilisés en microélectronique et pouvant avoir des applications aussi bien microélectroniques qu'optoélectroniques, optiques, en hyperfréquence,... Par un procédé similaire peuvent notamment être également collés sur un « support initial » une plaque monolithique, une structure empilée, une structure mise en forme, ou (selon un exemple qui ne fait pas partie de l'invention) un film, et ce sur leur surface active ou non, avec ou sans « vias »... De même, le « support initial » de collage ne doit pas être restreint à l'exemple précédent de « plaque hôte de composé électronique », mais peut comprendre les mêmes différents éléments que décrits précédemment pour l'élément collé.

Le procédé peut ainsi être répété plusieurs fois, pour aboutir à une structure à multiples niveaux. Telle que représentée sur la figure 2, cette structure (10) peut par exemple consister en un empilement de composés (1, 1', 1"), par exemple de formes et/ou de tailles extérieures similaires mais de natures éventuellement différentes, chacun pouvant être solidarisé au précédent par une adhésion moléculaire, sur une couche de revêtement SiO₂ (5) dans le cas où la surface d'adhésion contient un polymère (4). L'une des structure tridimensionnelle (10) préférée ainsi réalisée est telle que la surface de chaque composé (1, 1'), recouverte d'un polymère (4), est totalement recouverte par une couche de SiO₂ (5) avant la mise en place sur cette couche (5) d'interface, qui est une couche d'adhésion moléculaire, du composé suivant (1', 1").

## Revendications

1. Procédé d'adhésion moléculaire d'un deuxième élément électronique (6) sur un premier élément électronique (1), dans lequel le premier et le deuxième éléments électroniques (1, 6) sont des plaques comprenant des composants ou dans lequel le deuxième élément électronique (6) est un composant électronique ou une puce et le premier élément électronique (1) est une plaque hôte ou une plaque monolithique ou une structure empilée, dans lequel la surface de contact du premier élément électronique (1) contient un polymère (4), le procédé comprenant le revêtement par une couche de liaison (5) d'au moins un partie de la surface du polymère (4) contenu à la surface du premier élément électronique (1), l'adhésion moléculaire s'opérant entre ladite couche de liaison (5) et le deuxième élément électronique (6), et dans lequel le premier et le deuxième éléments électroniques (1, 6) sont aptes à avoir des applications microélectroniques, optoélectroniques, optiques ou hyperfréquences.

2. Procédé selon la revendication 1 comprenant le nettoyage de la surface de contact du deuxième élément électronique (6) et/ou son recouvrement par une couche (7) de nature analogue à la couche de liaison (5).

3. Procédé selon l'une des revendications 1 ou 2 comprenant l'amincissement du deuxième élément électronique (6) après son adhésion sur la couche de liaison (5).

4. Procédé selon l'une des revendications 1 à 3 comprenant le traitement thermique de l'ensemble des deux éléments électroniques (1, 6) après adhésion.

5. Procédé selon l'une des revendications 1 à 4 dans lequel le revêtement se fait par dépôt d'une couche de liaison (5) d'épaisseur comprise entre 50 et 300 nm.

6. Procédé selon l'une des revendications 1 à 5 comprenant le polissage de la couche de liaison (5) .

7. Procédé selon l'une des revendications 1 à 6 comprenant l'activation de la couche de liaison (5) .

8. Procédé selon l'une des revendications 1 à 7 comprenant la réticulation du polymère (4) préalablement à son revêtement.

9. Procédé selon l'une des revendications précédentes dans laquelle la couche de liaison (5) est constituée d'oxyde de silicium.

10. Procédé de fabrication d'une matrice (10) d'éléments électroniques (1) empilés comprenant la mise en forme d'au moins un premier élément électronique (1) telle que la surface du premier élément électronique (1) soit au moins partiellement constituée d'un polymère (4), et l'adhésion sur cette surface du deuxième élément électronique (6) selon le procédé défini dans l'une des revendications 1 à 9.

11. Matrice tridimensionnelle (10) de composés électroniques (1), chaque composé électronique comprenant des composants électroniques (3) et comprenant une surface d'adhésion contenant un polymère (4), ladite matrice comprenant une pluralité de couches d'interface (5), les couches d'interface étant des couches d'adhésion moléculaire, la superficie de chacune des couches d'interface (5) étant au moins égale à la surface de la matrice (10) au niveau de ladite couche d'interface (5), telle qu'une partie au moins de chacune des couches d'interface (5) sépare directement un polymère (4) au niveau de la surface d'adhésion d'un des composés électroniques d'au moins un composant électronique (3) compris dans le composé électronique (1') adjacent.

12. Matrice selon la revendication 11 constituée d'un empilement de composés électroniques (1, 1') chaque composé (1) étant de mêmes formes et/ou dimensions que l'élément adjacent (1') dont il est séparé par une couche d'interface (5).

13. Matrice selon l'une des revendications 11 ou 12 dans laquelle les couches d'interface (5) sont constituées d'oxyde de silicium, de nitrure de silicium et/ou d'oxynitrure de silicium.

## Patentansprüche

1. Verfahren zur molekularen Adhäsion eines zweiten elektronischen Elements (6) auf einem ersten elektronischen Element (1), wobei das erste und das zweite elektronische Element (1, 6) Platten sind, die Komponenten enthalten, oder wobei das zweite elektronische Element (6) eine elektronische Komponente oder ein Chip ist und das erste elektronische Element (1) eine Trägerplatte oder eine monolithische Platte oder eine Stapelstruktur ist, wobei die Kontaktfläche des ersten elektronischen Elements (1) ein Polymer (4) enthält, wobei das Verfahren das Beschichten von zumindest einem Teil der Oberfläche des an der Oberfläche des ersten elektronischen Elements (1) enthaltenen Polymers (4) mit einer Bindeschicht (5) umfasst, wobei die molekulare Adhäsion zwischen der Bindeschicht (5) und dem zweiten elektronischen Element (6) erfolgt, und wobei das erste und zweite elektronische Element (1, 6) dazu geeignet sind, bei mikroelektronischen, optoelektronischen, optischen oder Mikrowellenanwendungen verwendet zu werden.

2. Verfahren nach Anspruch 1, umfassend das Reinigen der Kontaktfläche des zweiten elektronischen Elements (6) und/oder deren Überdecken mit einer Schicht (7), deren Beschaffenheit derjenigen der Bindeschicht (5) entspricht.

3. Verfahren nach einem der Ansprüche 1 oder 2, umfassend das Verjüngen des zweiten elektronischen Elements (6) nach dessen Adhäsion auf der Bindeschicht (5).

4. Verfahren nach einem der Ansprüche 1 bis 3, umfassend die Wärmebehandlung der Einheit aus beiden elektronischen Elementen (1, 6) nach der Adhäsion.

5. Verfahren nach einem der Ansprüche 1 bis 4, wobei das Beschichten durch Aufbringen einer Bindeschicht (5) mit einer Dicke zwischen 50 und 300 nm erfolgt.

6. Verfahren nach einem der Ansprüche 1 bis 5, umfassend das Polieren der Bindeschicht (5).

7. Verfahren nach einem der Ansprüche 1 bis 6, umfassend das Aktivieren der Bindeschicht (5).

8. Verfahren nach einem der Ansprüche 1 bis 7, umfassend das Vernetzen des Polymers (4) vor dessen Beschichten.

9. Verfahren nach einem der vorangehenden Ansprüche, wobei die Bindeschicht (5) aus Siliziumoxid besteht.

10. Verfahren zur Herstellung einer Matrix (10) aus gestapelten elektronischen Elementen (1), umfassend das Umformen zumindest eines ersten elektronischen Elements (1) so, dass die Oberfläche des ersten elektronischen Elements (1) zumindest teilweise aus einem Polymer (4) besteht, und die Adhäsion des zweiten elektronischen Elements (6) auf dieser Oberfläche gemäß dem Verfahren nach einem der Ansprüche 1 bis 9.

11. Dreidimensionale Matrix (10) aus elektronischen Verbindungen (1), wobei jede elektronische Verbindung elektronische Komponenten (3) enthält und eine Adhäsionsschicht aufweist, die ein Polymer (4) enthält, wobei die Matrix eine Vielzahl von Grenzflächenschichten (5) enthält, wobei die Grenzflächenschichten Schichten mit molekularer Adhäsion sind, wobei die Oberfläche einer jeden der Grenzflächenschichten (5) zumindest gleich der Oberfläche der Matrix (10) im Bereich der Grenzflächenschicht (5) ist, so dass zumindest ein Teil einer jeden der Grenzflächenschichten (5) direkt ein Polymer (4) im Bereich der Adhäsionsfläche einer der elektronischen Verbindungen von zumindest einer elektronischen Komponente (3) trennt, die in der benachbarten elektronischen Verbindung (1') enthalten ist.

12. Matrix nach Anspruch 11, bestehend aus einer Stapelung von elektronischen Verbindungen (1, 1'), wobei jede Verbindung (1) die gleichen Formen und Abmessungen wie das benachbarte Element (1') hat, von dem sie durch eine Grenzflächenschicht (5) getrennt ist.

13. Matrix nach einem der Ansprüche 11 oder 12, wobei die Grenzflächenschichten (5) aus Siliziumoxid, Siliziumnitrid und/oder Siliziumoxinitrid bestehen.

## Claims

1. Method for molecular adhesion of a second electronic element (6) on a first electronic element (1), wherein the first electronic element and the second electronic element (1, 6) are wafers comprising components or wherein the second electronic element (6) is an electronic component or a chip and the first electronic element (1) is a host wafer or a monolithic wafer or a stacked structure, wherein the contact surface of the first electronic element (1) contains a polymer (4), the method comprising the coating, with a bonding layer (5), of at least some of the surface of the polymer (4) contained at the surface of the first electronic compound (1), with the molecular adhesion taking place between said bonding layer (5) and said second electronic element (6), and wherein the first electronic element and the second electronic element (1, 6) able to have microelectronic, optoelectronic, optic, or hyper-frequency applications.

2. Method according to claim 1 comprising the cleaning of the contact surface of the second electronic element (6) and/or its coating with a layer (7) similar to the bonding layer (5).

3. Method according to one of claims 1 or 2, comprising the thinning of the second electronic element (6) after adhesion thereof to the bonding layer (5) .

4. Method according to one of claims 1 to 3, comprising the heat treatment of the assembly of the two elements (1, 6) after adhesion.

5. Method according to one of claims 1 to 4, wherein the coating is produced by deposition of a bonding layer (5) having a thickness between 50 and 300 nm.

6. Method according to one of claims 1 to 5 comprising the polishing of the bonding layer (5).

7. Method according to one of claims 1 to 6 comprising the activation of the bonding layer (5).

8. Method according to one of claims 1 to 7 comprising the cross-linking of the polymer (4) prior to the coating thereof.

9. Method according to one of the previous claims, wherein the bonding layer (5) consists of silicon oxide.

10. Method for producing an array (10) of stacked electronic elements (1) comprising the development of at least one first electronic compound (1) so that the surface of the first electronic compound at least partially consists of a polymer (4), and the adhesion on this surface of a second compound (6) according to the method defined in one of claims 1 to 9.

11. Three-dimensional array (10) of electronic compounds (1), each electronic compound (1) comprising electronic components (3) and an adhesion surface containing a polymer (4), said array comprising a plurality of interface layers (5), said interface layers (5) being molecular adhesion layers, wherein each of the interface layers (5) is at least equal to the surface of the array (10) at the level of said interface layer (5), so that at least some of the interface layers (5) directly separate a polymer (4) at the level of the adhesion surface of one of said electronic compounds of at least one electronic component comprised in the adjacent electronic compound (1').

12. Array according to claim 11, consisting of a stack of electronic compounds (1, 1'), wherein each compound (1) has the same shape and/or size as the adjacent compound (1') from which it is separated by an interface layer (5).

13. Array according to one of claims 11 or 12, wherein the interface layers (5) consist of silicon oxide, silicon nitride and/or silicon oxynitride.
